# EUROPEAN PATENT APPLICATION

(11) **EP 1 560 052 A1**
(43) Date of publication of application: **03.08.2005**
(21) Application number: 05250492.5
(22) Date of filing: 31.01.2005
(51) Int. Cl.: G02B 6/42, H01S 5/14

(54) **Method and apparatus for adjusting the path of an optical beam**

(30) Priority: 02.02.2004 US 770141; 03.08.2004 US 910756
(71) Applicant: Picarro, Inc., Sunnyvale, CA 94085-4705 (US)
(72) Inventor: Koulikov, Serguei, Picarro, Inc., Sunnyvale, CA 94085-4708 (US); Vacca, Giacomo, Picarro, Inc., Sunnyvale, CA 94085-4708 (US); Richman, Bruce, Picarro, Inc., Sunnyvale, CA 94085-4708 (US); Kachanov, Alexander, Picarro, Inc., Sunnyvale, CA 94085-4708 (US); Kharlamov, Boris, Picarro, Inc., Sunnyvale, CA 94085-4708 (US); Knippels, Guido, Picarro, Inc., Sunnyvale, CA 94085-4708 (US); Rella, Christopher, Picarro, Inc., Sunnyvale, CA 94085-4708 (US); Pham, Hoa, Picarro, Inc., Sunnyvale, CA 94085-4708 (US)
(74) Representative: Benson, John Everett

(57) **Abstract**

A method and apparatus for adjusting the path of an optical beam and in particular, a method and apparatus for improving the coupling efficiency (power input) of free-space radiation into an optical waveguide using, as part of an optical train, a weak lens positioned along the path of the optical beam (the Z axis) and adapted to adjust the path of the beam. The weak lens is translatable along the Z axis and also along at least one axis perpendicular to the Z axis (the X or Y axes). In a preferred embodiment, the weak lens possesses all three positional degrees of freedom (i.e., it is adjustable along all of the X, Y, and Z axes). In certain preferred embodiments, the weak lens is also capable or one or even two orientational degrees of freedom (i.e., pitch and/or yaw).

## Description

### Field of The Invention.

This invention relates to a method and apparatus for adjusting the path of an optical beam. In particular, this invention is directed to a method and apparatus for improving the coupling efficiency (power input) of free-space radiation into optical waveguides using, as part of an optical train, a weak lens positioned along the path of the optical beam (the Z axis) and adapted to adjust the path of the beam. In accordance with the present invention, the weak lens is translatable along the Z axis and also along at least one axis perpendicular to the Z axis (the X or Y axes). In a preferred embodiment, the weak lens possesses all three positional degrees of freedom (i.e., it is adjustable along all of the X, Y, and Z axes). In certain preferred embodiments, the weak lens is also capable of one or even two orientational degrees of freedom (i.e., pitch and/or yaw).

### Background of the Invention.

In many optical products, a collimated light beam needs to be coupled into a micron-sized waveguide structure. For example, in the case of an optical fiber telecommunication system, the core of an optical fiber has a relatively small diameter (typically less than about 10 µm). Additionally, optical fibers and other waveguides frequently have relatively narrow input angles within which light is accepted. Accordingly, the light source must be carefully aligned with a receiving fiber in order to avoid coupling power losses and/or other performance problems. In order to couple efficiently, a strongly focusing lens ("strong lens"), e.g., a lens with a focal length broadly in the range of 0.2 mm to 10 mm and typically between 0.5 mm and 5 mm, is used to produce a focused spot size matched as closely as possible to the diameter or cross-sectional area of the waveguide structure. With this method, good coupling efficiency can theoretically be achieved. However, a major challenge is to maintain optimum alignment of the other components of the optical train to the waveguide structure following the permanent attachment step of the waveguide and other optical components to a common rigid support structure, which permanent attachment is normally required in practical applications. In the case of a laser system, such a support structure is normally an optical bench or, where the system is portable, a housing having a rigid base plate. A shift in one or more of the optical components can occur not only when they are permanently attached, but also if any thermal conditioning of the components is carried out. In the case of lasers, a shift of a strongly focusing optical component by even a fraction of the waveguide diameter (typically micron-sized) can have a significant impact on the amount of radiation coupled into the waveguide and therefore on the efficiency and overall performance of the product. Numerous approaches to steering the beam output (or input) in fiber-optic packaging and other waveguide applications have been proposed. For example, steering may be desired when light is to be coupled into or out of the end of a single-mode fiber within a fiber-optic communication system. In such applications, it is desirable to correct for even slight lateral displacements of the fiber's tip. Over the years, various attempts have been made to adjust the paths of optical beams in order to improve their direction and alignment. For example, US Patent No. 6,374,012 teaches the use of a magnetically mounted weak lens having only X and Y degrees of freedom (i.e., allowing for movement only in a plane perpendicular to the path of beam propagation) for optic fiber alignment.

However, we have found that adjustment of an optical beam path in only the X and Y axes is not always sufficient. Moreover, it has been discovered that, for optimum performance, component adjustments often need to be finely "tuned" or "trimmed" after an initial adjustment is made. Accordingly, there exists a need for an improved method and apparatus for adjusting the path of an optical beam in such a way as to overcome the deficiencies of the prior art. In particular, there remains a need for a method and apparatus that can steer (alter the position of) an optical beam in the Z axis (the axis of beam propagation) and also along at least one of the X or Y axes, and preferably all three (X, Y, and Z axes). Not only is it desirable for the beam path to be adjustable in the X, Y, and Z axes, i.e., to have all three degrees of positional freedom, but we have also found that it is sometimes advantageous to provide a weak lens mount configured so that a weak lens in the beam path can also be adjusted (tilted) to alter its pitch and/or yaw.

Although there are numerous known, essentially permanent attachment processes for optical components (e.g., laser welding, UV or thermally activated adhesives, soldering, etc.), all of these processes can cause a shift in the location of the optical component during the attachment process. The basic problem is that in general optical components are aligned, and the optical system tested to achieve optimum performance, of necessity before all the major optical components are firmly, i.e., essentially permanently affixed to a mount, container or other rigid structure. This is necessary because some repositioning or realignment of components in what is sometimes referred to as the "optical train" (i.e., the collection of optical components placed along the optical beam path) is frequently required during the initial assembly and testing. Only after such initial assembly and testing are the optical components firmly affixed (i.e., mounted) so that they will not subsequently shift position during shipment, installation and/or operation. Additionally, after the initial assembly, or even after the final permanent mounting, a baking, annealing or other thermal treatment of the assembled components is frequently required or desirable. The frequent effect of the final permanent mounting and/or heat treatment is to cause a positional shift in one or more of the critical optical train components, thereby adversely affecting the coupling of radiation (i.e., the power) into the waveguide.

### Summary of the Invention.

We have found a solution to this unwanted optical component shift, which is to add to the optical train another optical component, in particular, a weakly focusing lens ("weak lens"), e.g., a lens which has a focal length in the range of about 10 mm to 500 mm and typically between about 20 mm and 200 mm, which weak lens allows one to correct for the aforementioned shift by providing, in conjunction with the weak lens, a mounting system which permits movement of the weak lens along the Z and at least one of the X or Y axes, and preferably along all three of the X, Y, and Z axes, and most preferably to also adjust the pitch and/or yaw of the weak lens.

A weak lens (sometimes referred to as a "secondary" lens) is positioned along the path of the optical beam, and the weak lens is spaced apart from the strong ("primary") lens. The weak lens has a focal length the magnitude of which is greater than that of the primary lens, and the weak lens is mounted so as to permit movement collinearly with the optical beam (i.e., along the Z axis) and also along the plane that traverses the path of the optical beam (the X and Y axes). In accordance with the present invention, the weak lens is configured to adjust the focusing and path of the optical beam upon movement of the weak lens collinearly with the beam path and in the X and/or Y direction(s) along said plane. Because the additional component (the weak lens) has a larger focal length than the primary lens, it has larger tolerances for attachment, as will be explained hereafter in greater detail. We have discovered that coupling collimated free-space optical radiation into micron-sized waveguides (e.g., ridge waveguides, buried-channel waveguides, semiconductor gain chips, single-mode fibers, periodically poled ferroelectric crystal waveguides, and the like) is greatly improved by the use of a weak lens adjustable along the Z and X and/or Y axes in combination with the normally used strong lens. The weak lens enables one to compensate for losses in the coupling efficiency caused by motion of one or more of the critical optical components (e.g., the strong lens and/or the waveguide) during the attachment and/or thermal conditioning process.

By adding an appropriately mounted weak lens, adjusting it to optimize coupling, and then rigidly attaching the weak lens only after the critical optics (especially the waveguide and the strong lens) have been substantially immovably attached, losses in the coupling efficiency into the waveguide can be substantially recovered by moving the weak lens in the Z and X or Y axes, as appropriate. Adjustments of the weak lens in the X and Y direction are used to compensate for any shifts along the X and Y axes that have occurred in the critical optics during attachment. The X and Y shifts in the weak lens enable one to re-center the optical beam on the waveguide entrance. Shifting the weak lens in the Z direction (along the beam axis) is required if the strongly focusing optics are no longer producing the optimum spot size or focal position at the waveguide entrance, but rather producing an over-focused or under-focused optical beam, or a focus before or after the waveguide entrance. Therefore, although it may not always be necessary for the weak lens to be adjustable in both the X and Y axes, it is preferred that the weak lens mount be able to move the weak lens along all three of the X, Y, and Z axes. The choice of focal length for the weak lens determines the amount of correction that can be applied by shifting it in the X, Y, and Z directions.

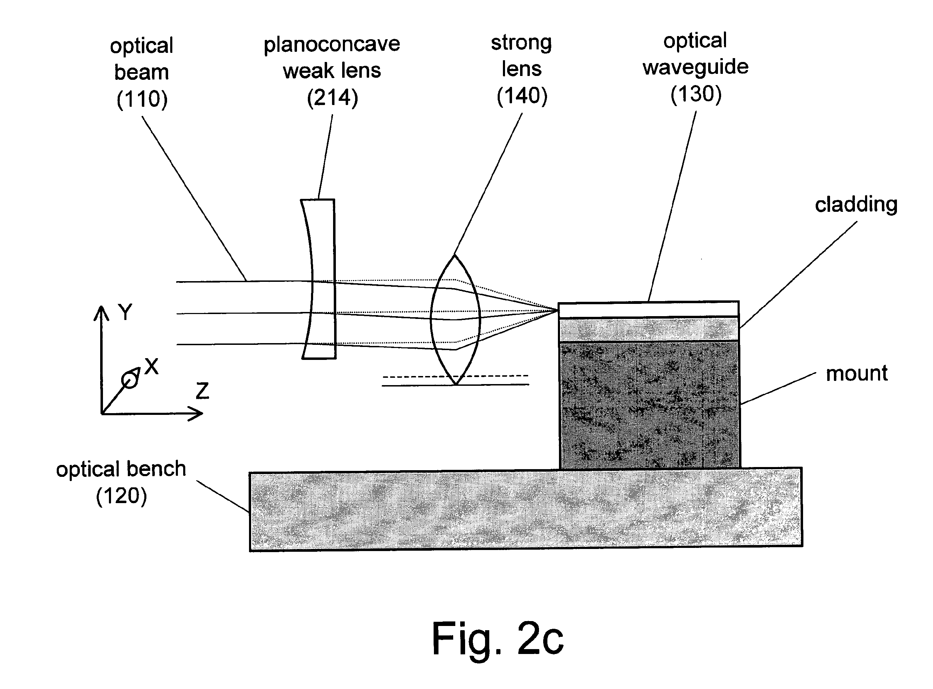

The terms "weak" lens and "strong" lens, as used herein, indicate the relative strength of lenses used in an optical assembly. Generally, weak lenses have focal lengths of greater magnitude. Accordingly, as the term is used herein, a "weak" lens has a focal length the absolute value of which is greater than that of a "strong" lens. In practice this means that the weak lens should have a focal length whose absolute value is broadly in the range of about 10 to 100 times, and preferably about 20 to 50 times, that of the strong lens. Thus, the strong lens will have a focal length ranging from about 0.2 mm to about 20 mm, preferably from about 1 mm to 10 mm. The specific values of focal lengths of the various optical elements in the system (and hence the ratio of focal lengths) will depend on application-specific design considerations, such as the optimum collimated beam diameter, the dimensions and numerical aperture of the waveguide or waveguides, and free-space propagation distances. The term "absolute value" is used since it is not necessary that the weak lens be "positive" and a "negative" weak lens can also be used, as illustrated in the subassembly shown in Fig. 2c.

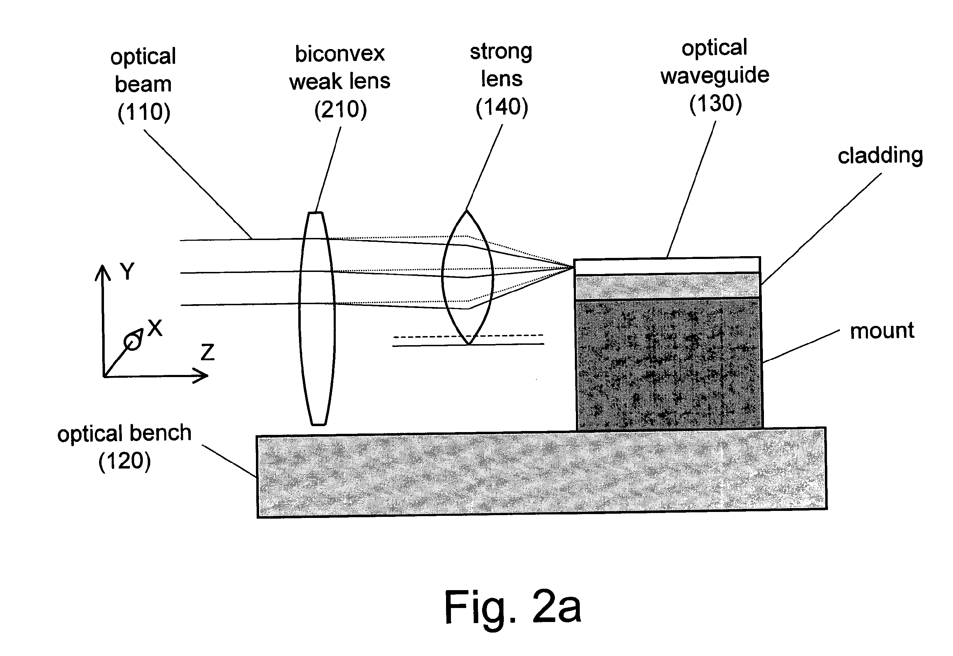

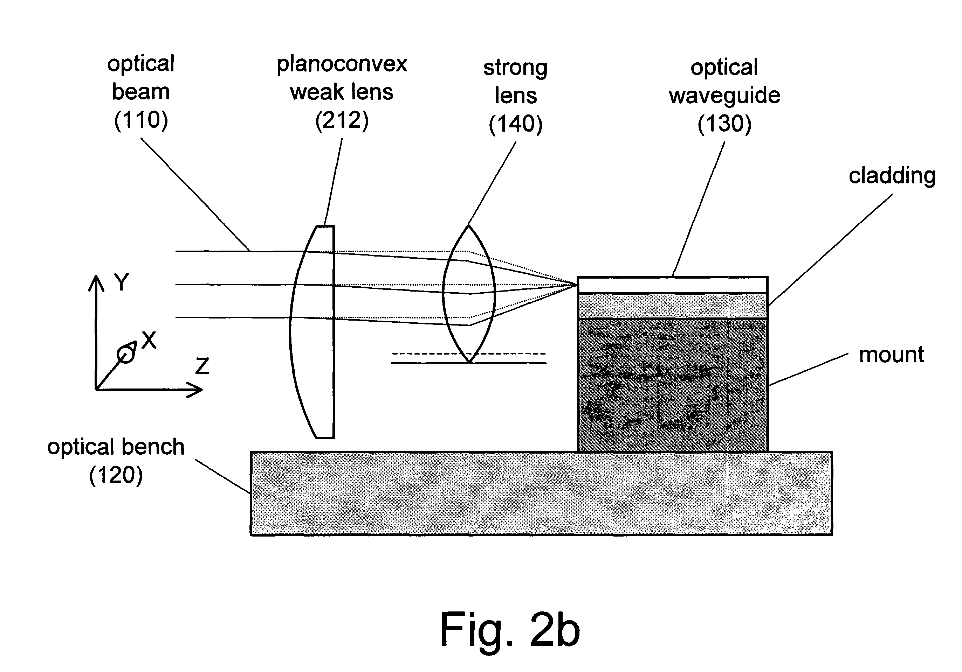

Although the majority of the Figures show planoconvex lenses, other weak lenses can be used instead, e.g., a biconvex lens as shown in Fig. 2b or a planoconcave lens as shown in Fig. 2c. In addition to negative lenses, one can use HOEs (Holographic Optical Elements) and variable-index lenses such as GRIN (GRadient INdex) lenses as the weak lens. Lenses that are "off-axis" can be used as well, their action being akin to the serial combination of a centered lens and a wedge. The beam will be somewhat deflected by such an off-axis weak lens, but the amount of deflection will allow for adjustable compensation. Note also that the weak lens can be positioned either between the optical source and the strong lens or between the strong lens and the waveguide.

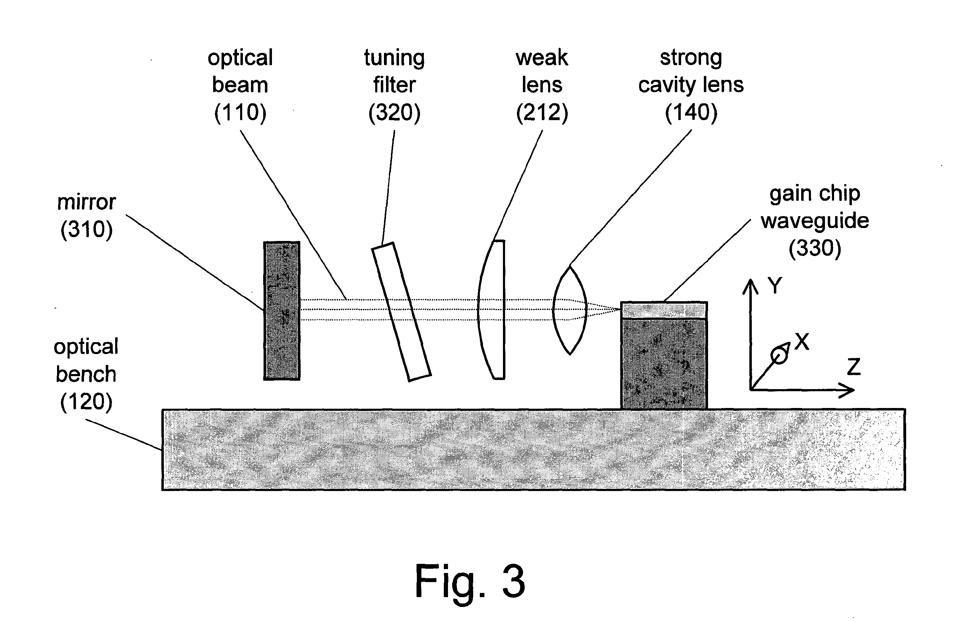

In some embodiments of the present invention the strong lens will function solely or, at least, primarily as a focusing lens. In other embodiments a second strong lens whose primary function will be to collimate the optical beam will also be present in the optical train. In an external-cavity laser (e.g., as shown in Fig. 3) the strong lens serves as both a focusing and a collimating lens. It should also be noted that many laser or other optical systems incorporate optical isolator components and/or one or more steering mirrors or other components in the optical train. The inclusion of any such components or an additional strong lens does not alter the advantages resulting from incorporating, in accordance with the present invention, a weak lens having Z and X or Y, or preferably all three, degrees of positional freedom, to achieve precise focusing into the waveguide. The basic requirement is that the weak lens be the last component in the optical train, or in a section of the optical train, which is adjusted to optimize the focus of the optical beam into the waveguide and then be fixedly mounted.

It is to be understood that both the foregoing general description and the following detailed description are exemplary and are not to be construed as limiting the scope of the invention as defined by the claims.

### Brief Description of the Drawings.

The invention will now be described with reference to the specific embodiments selected for illustration in the drawings. It will be appreciated that the spirit and scope of this invention is not limited to the illustrated embodiments. Various modifications may be made within the range of equivalents of the illustrated embodiments without departing from the spirit and scope of the invention. It will further be appreciated that the drawings are not rendered to any particular scale or proportion and that the comparative dimensions of the various elements shown in the drawings are expanded or reduced as appropriate for the sake of clarity.
Figures 1a and 1b illustrate the deleterious effect, in prior art products, of unwanted (e.g., curing-induced) shifts in the position of a strongly focusing lens, with the attendant misalignment of the focused beam from its proper position on the waveguide entrance.
Figure 2a shows the use of a biconvex weak lens having arbitrary surface curvatures being used in accordance with the current invention (by shifting it along the Y axis) to compensate for beam misalignment due to relative shifts of the strong lens and the waveguide caused by permanent mounting and/or thermal treatment.
Figure 2b illustrates the use of a planoconvex weak lens in accordance with the current invention (again by shifting it along the Y axis) to compensate for beam misalignment due to relative shifts of the strong lens and the waveguide.
Figure 2c illustrates the use of a negative planoconcave weak lens in accordance with the current invention (also by shifting it along the Y axis) to compensate for beam misalignment due to relative shifts of the strong lens and the waveguide.
Figure 3 illustrates the use of a planoconvex weak lens in accordance with the present invention to enhance alignment in an external-cavity laser.
Figure 4 illustrates the use of a weak lens to achieve improved coupling of a laser beam between a single-mode optical fiber and a gain chip.
Figure 5a illustrates typical unrecoverable power losses experienced in laser-to-fiber coupling in the absence of an adjustable weak lens (such as would be provided by the present invention) as a laser of the type shown in Fig. 4, but without a weak lens, passes through various stages of the alignment and mounting process.
Figure 5b demonstrates the effectiveness of a weak lens in maintaining the power output of three different realizations of the laser-to-fiber coupling embodiment shown in Fig. 4 as they pass through various stages of the alignment and mounting process.
Figure 6 shows that even comparatively large movements of the weak lens have only a limited impact on power output in a realization of the laser-to-fiber coupling embodiment shown in Fig. 4.
Figure 7 illustrates the application of the weak-lens technique of the present invention to optimize the focusing of a laser beam into a frequency doubling crystal, in this example Periodically Poled Lithium Niobate (PPLN).
Figure 8 illustrates the use of a piano-convex weak lens to achieve maximum coupling efficiency between a gain chip waveguide and a semiconductor optical amplifier (SOA) waveguide.
Figure 9 illustrates the use of a bi-convex weak lens in accordance with the present invention to correct astigmatism occurring in coupling the output of a gain chip into a SOA waveguide. Note that the weak lens is shown as tilted, e.g., by using the mounting shown in greater detail in Figure 12a-d, which is capable of adjusting the pitch and yaw of the weak lens as well as translating it along the X, Y, and Z axes.
Figure 10 shows an isometric view of a mount in accordance with the present invention for a weak lens that is adjustable in the Z axis and also the X axis.
Figure 11a shows a front view of a lens mount in accordance with the present invention that is adjustable in all three of the X, Y, and Z axes.
Figure 11b shows a cross-sectional side view of the lens mount of Fig. 11a that is adjustable in all three of the X, Y, and Z axes.
Figure 12a shows a front view of a lens mount holder ("gripper") that can move the weak lens along any of the X, Y, and Z axes and also alter its pitch and/or yaw in accordance with the present invention.
Figure 12b shows a front view of the lens mount and gripper assembly of Fig. 12a and also a prism for permanently affixing the weak lens mount in accordance with the present invention.
Figure 12c shows a side view of the lens mount and prism of Fig. 12b after the mount and the prism have been permanently attached to each other and to the bench and the gripper assembly has been removed.
Figure 12d shows a side view of a modified realization of the lens mount assembly and prism of Fig. 12b illustrating the result of adjusting the pitch of the weak lens.

### Detailed description of the Invention.

Applications of this invention, all of which result in improved efficiency of the optical coupling, include by way of the examples described and illustrated below:
1) Laser external-cavity alignment
2) Laser-to-fiber coupling
3) Coupling of semiconductor pump laser to doubling crystal waveguide
4) Coupling of gain chip to SOA waveguide
5) Astigmatism compensation while coupling into a waveguide

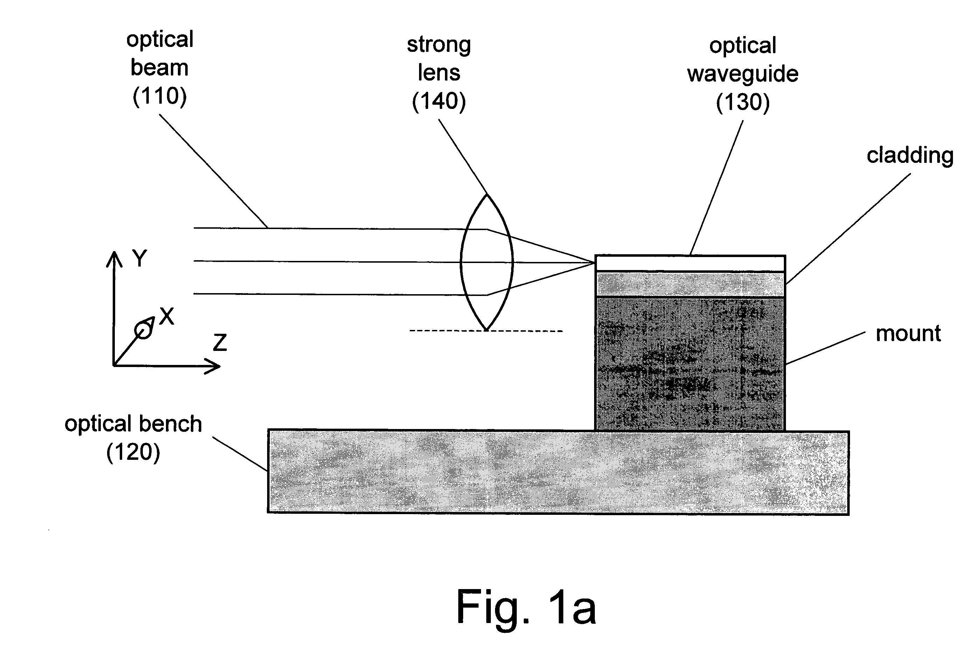

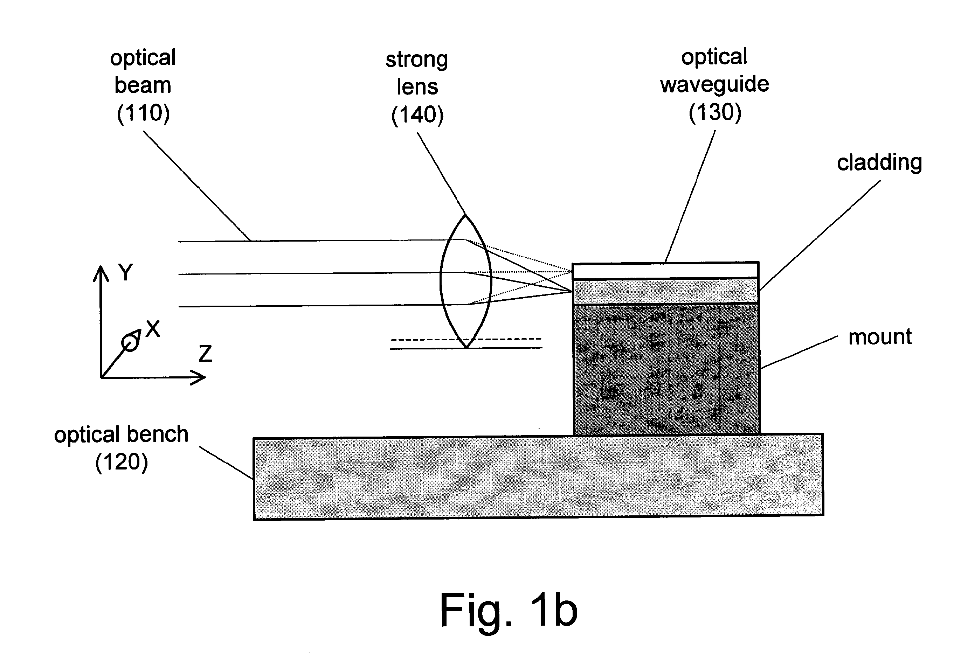

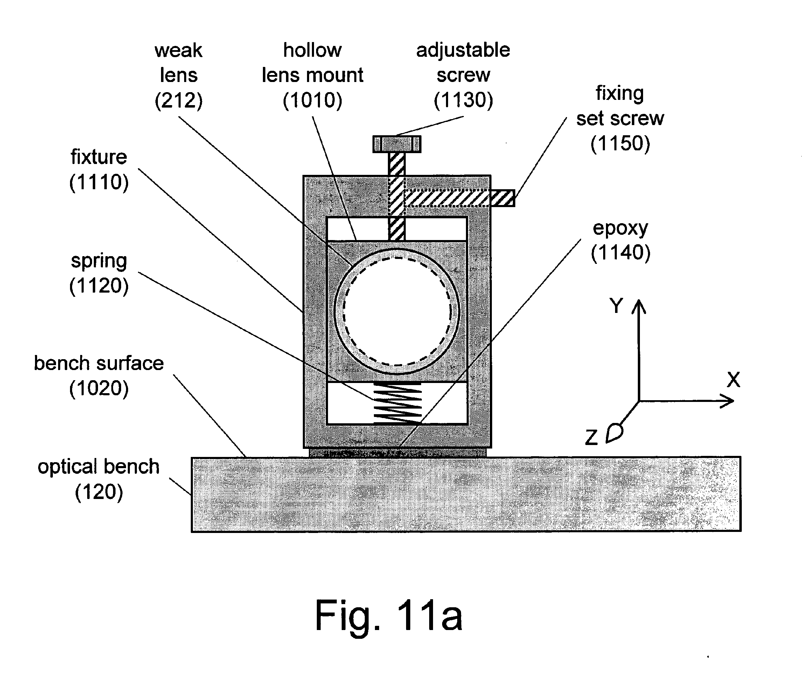

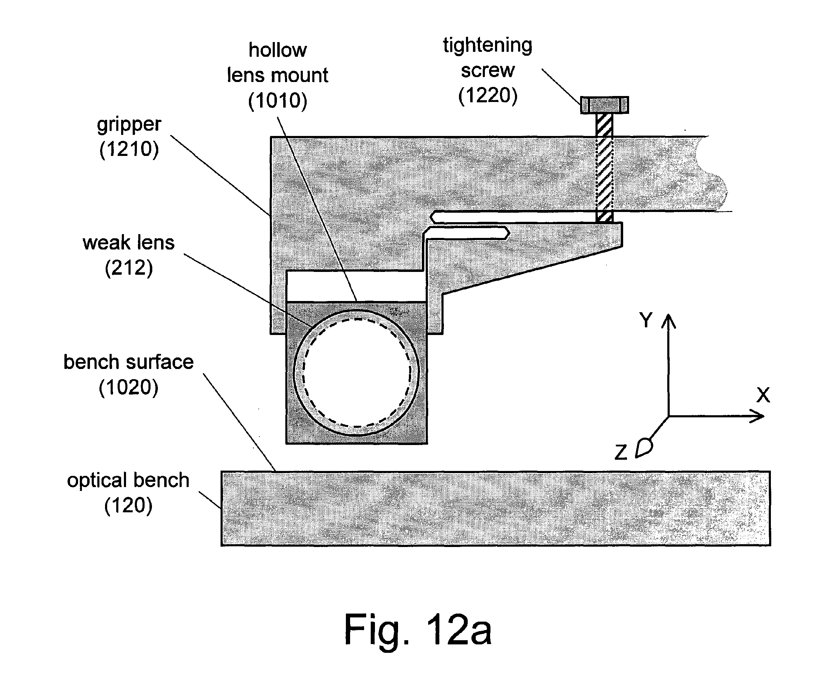

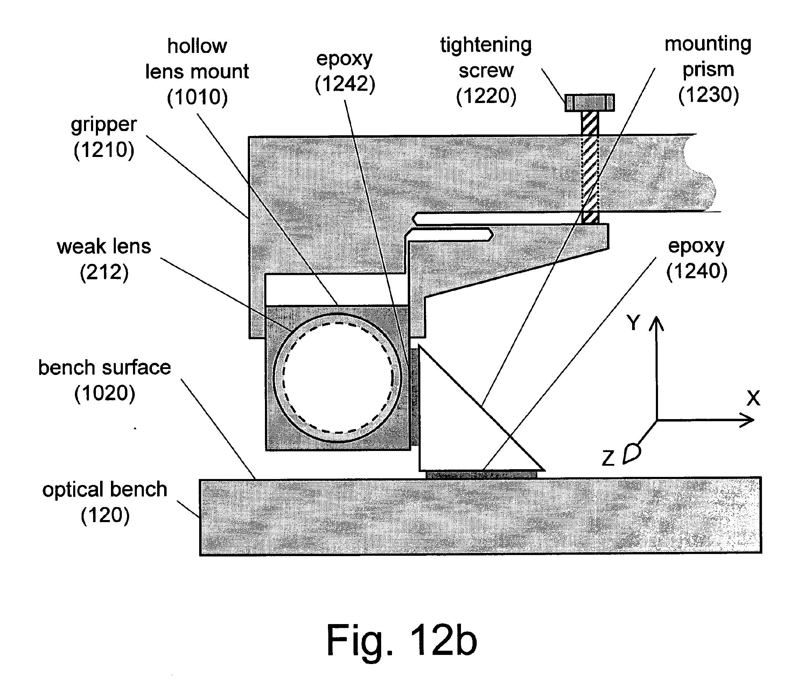

In the Figures like numbers may sometimes denote the same or substantially equivalent components. The X, Y and Z axes are shown in Figs. 1-4, 7-9, 11b, 12c, and 12d with the X axis being perpendicular to the plane of the drawing, and in Figs. 11a, 12a, and 12b with the Z axis being perpendicular to the plane of the drawing.

### Prior art (Figures 1a and 1b)

Figure 1a shows the basic design used in numerous prior art products whereby a strongly focusing lens (140) directs collimated radiation (an optical beam, 110) into an optical waveguide (130). Both the lens and the waveguide are affixed to an optical bench (120) or other rigid support structure. The radiation (of which three representative rays are drawn) is shown as being focused precisely onto the waveguide.

Figure 1b illustrates the effect, in prior-art designs lacking a weak lens, of even a slight shift in the position of the strong lens (140) along the Y axis resulting, for example, from a permanent mounting procedure and/or thermal treatment of the system. As can be seen, the optical beam (110) no longer focuses into the waveguide (130). Movement along the Z axis would alter the beam waist Z position relative to the waveguide input and thus the beam spot size at the waveguide input.

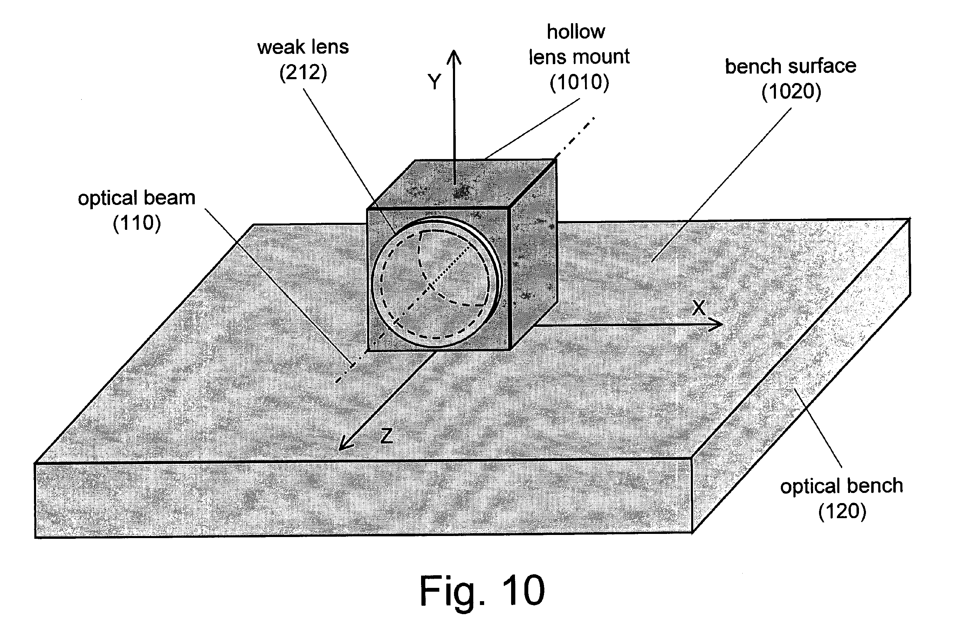

Turning to the present invention, and referring generally to the embodiments illustrated in Figs. 2-12, this invention provides a lens, such as is included in the optical train illustrated in Fig. 3, that is adapted to adjust the path of an optical beam. The actual design of suitable mounts for the weak lens in accordance with the present invention is not shown in Figs. 2-9. Alternative designs for the weak lens mounting according to the present invention are shown in Figs. 10, 11, and 12.

### Basic principle (Figures 2a, 2b, and 2c)

Figure 2a shows the use of a biconvex weak lens (210) having arbitrary surface curvatures being used in accordance with the current invention to correct any shift in position or focus of the optical beam (110) when the strong lens (140) and/or waveguide (130) shift position during their permanent mounting and/or thermal treatment. The weak lens of Fig. 2a is adjustable along all three of the X, Y, and Z axes. Adjustment of the weak lens along the Z axis maintains the optical beam spot size relative to the waveguide input cross-sectional area and beam waist Z position relative to the waveguide input face, while adjusting the weak lens along the X and/or Y axes enables the beam to remain precisely focused on the waveguide.

Figure 2b illustrates the use of a planoconvex weak lens (212) adjustable in accordance with the current invention to correct any shift in beam position or focus when the strong lens (140) and/or waveguide (130) shift position during permanent mounting and/or thermal treatment.

Figure 2c illustrates the use of a planoconcave weak lens (214) adjustable in accordance with the current invention to correct any shift in beam position or focus when the strong lens (140) and/or waveguide (130) shift position during permanent mounting and/or thermal treatment.

### Application 1: Laser external-cavity alignment (Figure 3)

Alignment of an external-cavity laser is a nontrivial problem, especially when rigid attachment of the optics to an optical bench is, as is frequently the case, required. The main reason for this problem is that the collimated optical beam (110) that propagates back and forth in the free-space part of the external cavity between the reflector (mirror 310) and the gain chip (330) must be efficiently coupled both into and out of the (same) ridge-waveguide gain chip. A strongly focusing cavity lens (140) is normally used to achieve this. Permanent attachment of this lens to an optical bench (120) or housing without incurring significant component movement is a major challenge. This process is greatly simplified when a weak lens (212) is added to the optical train, as shown, and adjusted to compensate for any shift of the strong lens that occurred during attachment. Note that a grating, or a combination of a grating and a mirror, can be used as a wavelength-selective reflecting element in lieu of the high reflecting mirror (310) and tuning filter (320) shown. Also, the relative positions of the filter and weak lens can be interchanged.

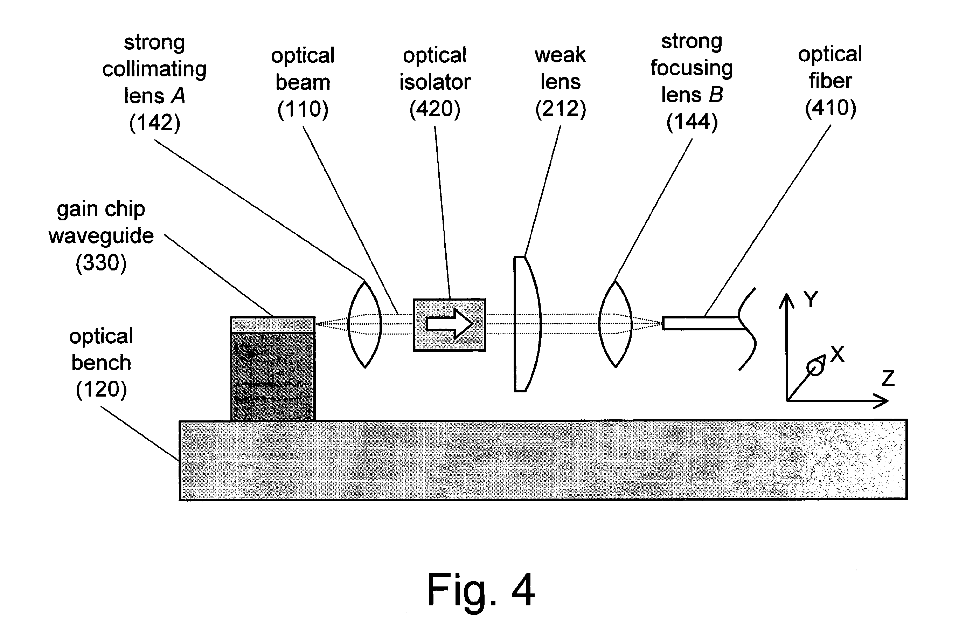

### Application 2: Laser-to-fiber coupling (Figures 4-6)

Similar attachment problems can exist in the fiber-coupling section of many lasers. As shown in Fig. 4, the radiation (optical beam 110) is first collimated out of a ridge-waveguide gain chip (330) and is focused into a single-mode optical fiber (410). Both the gain chip (330) and the single-mode fiber pigtail (410) are micron-sized optical waveguide structures. The addition of an appropriate weak lens (212) in the optical train allows recovery of losses that occur during alignment shifts resulting from permanent attachment of the collimating lens (strong lens *A,* 142), focusing lens (strong lens *B,* 144), gain chip (330), and/or fiber pigtail (410) to the optical bench (120). The laser of Fig. 4 can optionally include an optical isolator (420) to prevent back reflection, generally positioned between the weak lens and either strong lens.

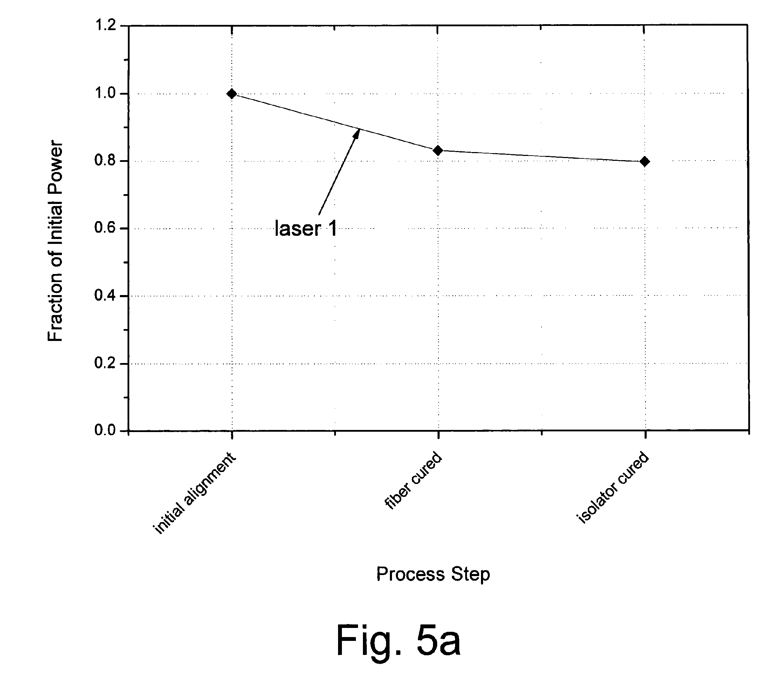

Figure 5a is a graph illustrating the effect of curing-induced shifts on the performance of a typical prior-art configuration (laser 1) such as one similar to that in Fig. 4 in the absence of a weak lens. The power output after initial alignment of the entire optical train (as well as permanent attachment of gain chip, collimating lens, and focusing lens to the optical bench) is assigned an arbitrary value of 1.0. It can be seen that subsequent curing of the fiber and isolator reduce the output power by approximately 20%. In the absence of a weak lens this power loss cannot be recovered, since the curing-induced beam misalignment is not retrievable.

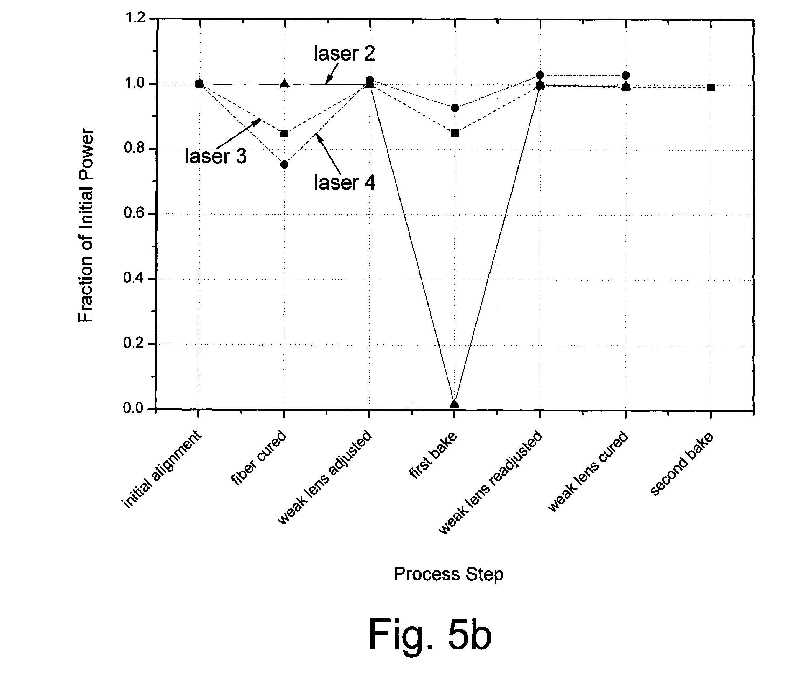

Figure 5b is a graph that shows the effect of a weak lens in maintaining the power output of three different examples of a laser of the type shown in Fig. 4. When all components are initially aligned and all but the fiber and the weak lens are rigidly affixed (i.e., mounted) on the optical bench, the power out of the fiber is assigned an arbitrary value of 1.0. The fiber is then rigidly affixed to the bench with, for example, a UV-cured epoxy resin. As can be seen in the case of laser 2, the epoxy cure caused essentially no change in fiber alignment and hence no change in power output. However, in the case of lasers 3 and 4, the epoxy fixation of the fiber caused a reduction in power output to relative values of about 0.85 and 0.75, respectively. Adjustment of the weak lens to reoptimize focusing of the optical beam brought the output for both lasers 3 and 4 back to 1.0. The laser assembly was then subjected to a thermal conditioning (designated "first bake"), which, depending on the laser, is normally carried out at between 85°C and 100°C for at least 1 hour, resulting in a reduction in power output for laser 3 again to about 0.85 and for laser 4 to about 0.93. Laser 2, which had been unaffected by the fiber fixation, had its power output reduced to approximately zero by the first bake. Adjustment of the weak lens returned all three lasers to at least the initial power output. Indeed, laser 4 produced slightly more power than the initial value. At this point the weak lens was firmly mounted ("cured") with epoxy. Because it is a weak lens, any slight alteration in its position resulting from the rigid mounting does not adversely affect the power output of the laser. This insensitivity in power output (or input) resulting from rigidly mounting the weak lens after mounting the rest of the optical train is shown by the fact that a second bake of laser 3 had no measurable effect on its power output.

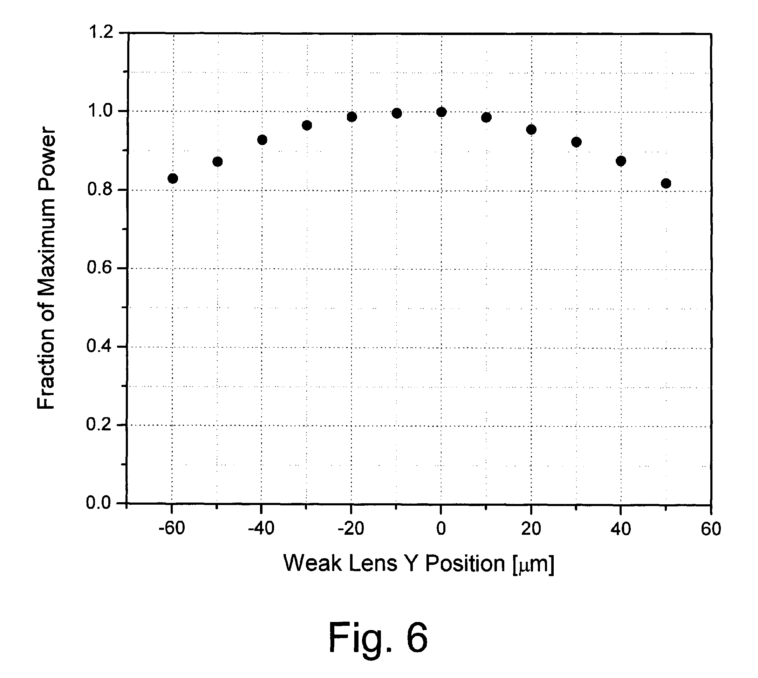

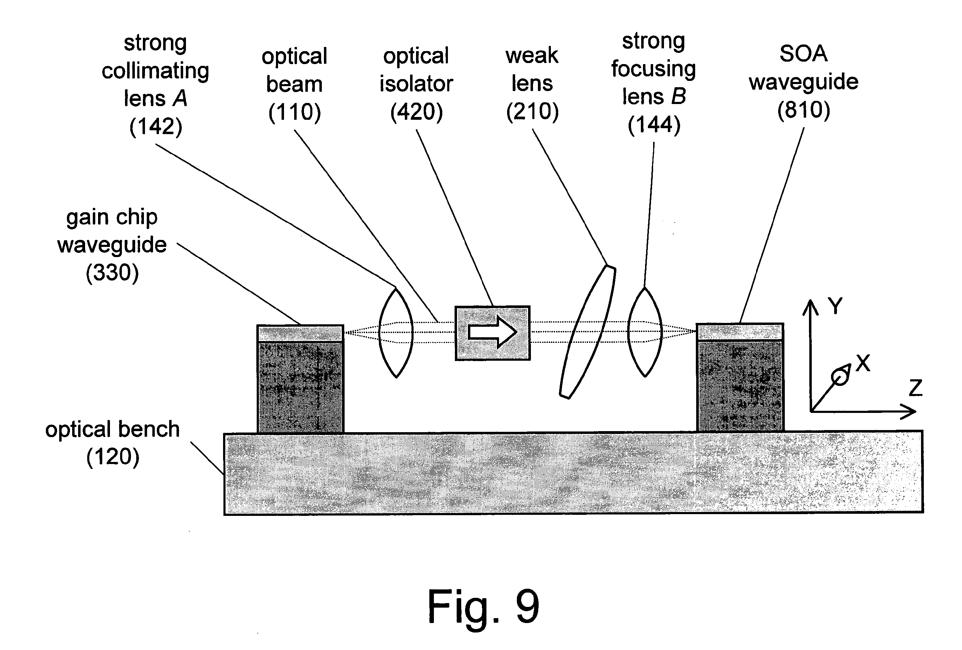

Figure 6 further demonstrates the fact that even comparatively large movements of the weak lens have only a limited impact on power output. For example, as shown here for the laser of Fig. 4, even a comparatively small 20% reduction in power output does not occur until the weak lens (in this particular example having a focal length of 72 mm, with the strong lens having a focal length of 2.5 mm) is moved at least 50 µm in one direction and 60 µm in the opposite direction. Since any movement resulting from the rigid fixing of the weak lens and/or a subsequent thermal treatment is unlikely to cause the weak lens to shift by more than a few µm, it is apparent from Fig. 9 that any such movement would have essentially no effect on laser power output after final processing of the other components of the optical train.

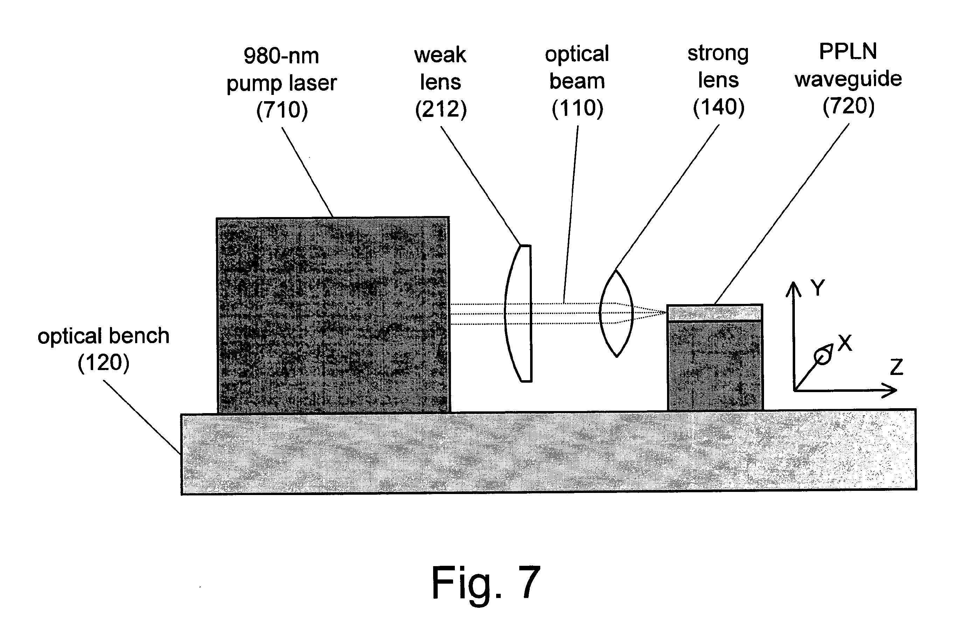

### Application 3: Coupling of semiconductor pump laser to doubling crystal waveguide (Figure 7)

When the collimated beam (110) from, for example, a 980-nm pump laser (710) is focused into a waveguide (720) etched in a, in this example, Periodically Poled Lithium Niobate (PPLN) frequency-doubling crystal, a strong lens (140) is used to match the focused spot size to the size of the input aperture of the doubling crystal waveguide. After attachment of this waveguide to a supporting bench (120), the coupling losses into the waveguide that normally occur due to any movement of the strong lens and/or waveguide can be compensated for by use of a weak lens (212) as shown. Movement of the weak lens along the Z axis maintains the correct correlation between the focused spot size and position and the waveguide input aperture. Other doubling crystals, such as Periodically Poled Lithium Tantalate (PPLT) and Periodically Poled Potassium Titanyl Phosphate (PPKTP), are suitable substitutes for PPLN.

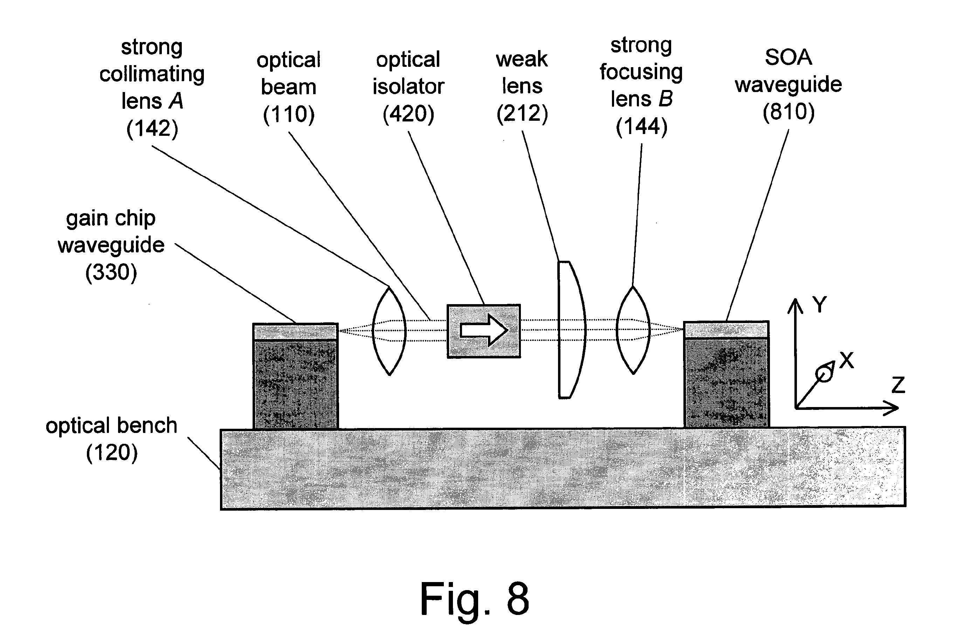

### Application 4: Coupling of gain chip to semiconductor optical amplifier (SOA) (Figure 8)

In the fabrication of some solid-state lasers, the output power directly out of the external-cavity laser may not be sufficient. One way to boost the output power is to send the laser beam through an additional amplifier stage such as a semiconductor optical amplifier (SOA). This involves coupling the radiation (optical beam 110) from the external-cavity laser waveguide (330) into the SOA waveguide (810). In general this is a challenging task because of the very small size of the waveguides used in both the gain chip and the SOA (generally in the range of 1 µm to 10 µm). Again, a weak lens (212) in the collimated part of the optical beam can be used to recover the losses resulting from shifts that occur during attachment of either or both of the strong lenses (*A*, 142, and *B*, 144) used for coupling into the SOA waveguide. In prior-art designs, an isolator has been used to prevent optical feedback and is normally placed between the two strong lenses. With the use of a weak lens as in the present invention, even as in Fig. 4, the isolator (420) can be situated between the weak lens and either of the strong lenses.

In reality, there are only a very limited number of strongly focusing lenses readily available from commercial vendors. The limited range of available focal lengths from which one can choose in a particular waveguide-coupling application has an impact on the maximum coupling efficiency that can be obtained in that application. When a weak lens is added either in the collimated section of the beam path or between the strongly focusing lens and the waveguide, the focusing properties of the lens pair are different from those of the strong lens alone. Thus, the weak lens provides an additional adjustment opportunity that allows one to alter, and thereby optimize, the focal length of the combination of weak and strong lens, thereby affording increased coupling efficiency.

### Application 5: Astigmatism compensation with a weak lens (Figure 9)

When radiation is coupled out of a semiconductor gain chip waveguide, it often has a degree of astigmatism. When the optical beam (110) from the chip (330) is collimated using a strong lens (*A*, 142) and subsequently coupled (focused) using another strong lens (*B*, 144) into another waveguide, such as the SOA (810) shown in Figure 9, the coupling efficiency in the SOA waveguide suffers from astigmatism, since the second strong lens cannot produce the optimal beam size and Z position in both the XZ and YZ planes. The use of a tilted (i.e., shifted in pitch and/or yaw) weak lens (210) provides adjustable focusing properties for both the XZ and YZ planes so that the astigmatism is corrected (or at the least reduced to an acceptable level) to thereby optimize the coupling into the second (i.e., SOA) waveguide. The desired astigmatism correction is achieved by adjusting the tilt (pitch and/or yaw angle) of the weak lens. Adjustments of up to fairly high tilt angles (up to about 15-20°) are possible, as this introduces only minimal higher-order aberrations in the optical beam that could adversely affect the coupling efficiency.

### Mounting methods (Figures 10-12)

Figure 10 shows a hollow lens mount (1010) positioned on optical bench (120) and holding weak lens (212), with the X, Y, and Z axes as shown. Optical beam (110) is shown passing through the lens along the Z axis. The flat base of the lens mount (1010), which interfaces with the planar top surface (1020) of the optical bench, allows translation of the lens mount along the Z and X axes although not the Y axis. Permanent fixation of the lens assembly is achieved, e.g., by applying and curing an adhesive (e.g., thermal- or UV-cure epoxy) in the form of a layer between the base of the lens mount and the surface of the optical bench, or as a bead around the base of the lens mount.

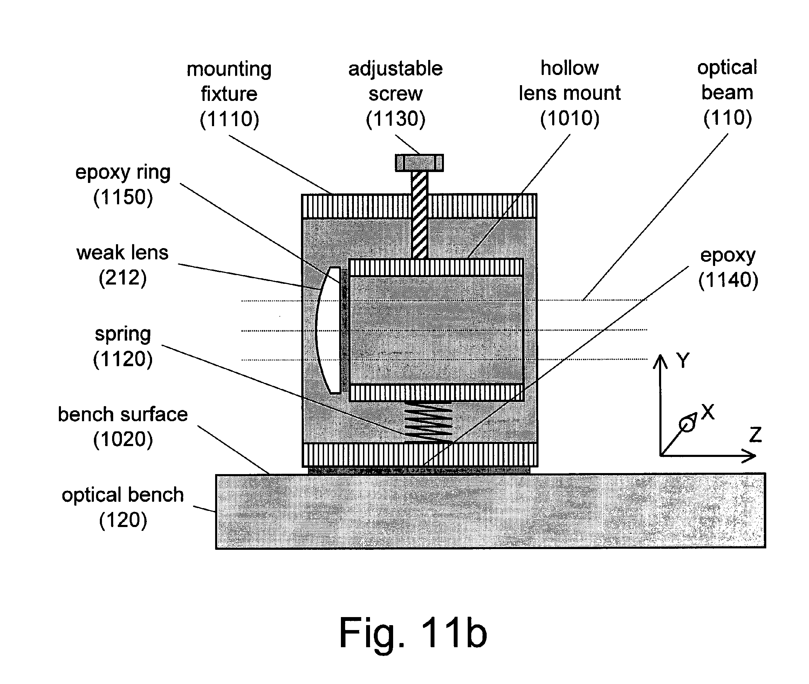

Figures 11a and 11b are front and cross-sectional side views, respectively, of a weak lens assembly that permits translation of a weak lens along all three of the X, Y, and Z axes. Again, (120) denotes an optical bench or the base plate used for mounting the optical train for a transportable packaged laser. In either case, the top surface (1020) of the bench or base plate will be substantially coplanar with the interfacing bottom surface of weak lens fixture (1110). In this configuration, weak lens (212) is held in a moveable hollow lens mount (1010) that is itself housed within the lens fixture (1110). Lens fixture (1110) is, even as mount (1010) shown in Fig. 10, moveable along the X and Z axes. However, as shown in Figs. 11a and 11b, lens (212) is affixed to mount (1010), the position of which (and therefore of lens (212)) is adjustable along the (vertical) Y axis within fixture (1110). Lens mount (1010) is shown as being supported within fixture (1110) by a spring (1120) controlled by a screw (1130) which passes through the top surface of fixture (1110) and which, by pressing the top of lens mount (1010), pushes the base of lens mount (1010) downwardly against compression spring (1120). By turning screw (1130) either clockwise (to push lens mount (1010) downwards further compressing the spring) or anti-clockwise (to enable spring (1130) to move the lens mount (1010) upward), the position of weak lens (212) on the Y axis will be adjusted. Permanent fixation of the lens assembly against movement along the X and Z axes can be achieved, e.g., by applying and curing an adhesive (e.g., thermal- or UV-cure epoxy) in the form of a layer (1140) between the base of the fixture (1110) and the surface of the optical bench (1020), or as a bead around the base of the fixture (1110). Permanent fixation of the lens assembly against movement along the Y axis is achieved, e.g., by applying and curing an adhesive in the form of a layer between the sides of lens mount (1010) and the inner walls of fixture (1110), or by fixing the adjustable screw (1130) by means of an optional set screw (1150) with a compressible tip to apply sufficient holding pressure. Of course, other known designs of lens holder that enable movement of a lens along the X, Y, and Z axes and that are available in the art may be utilized without departing from the spirit and scope of the present invention.

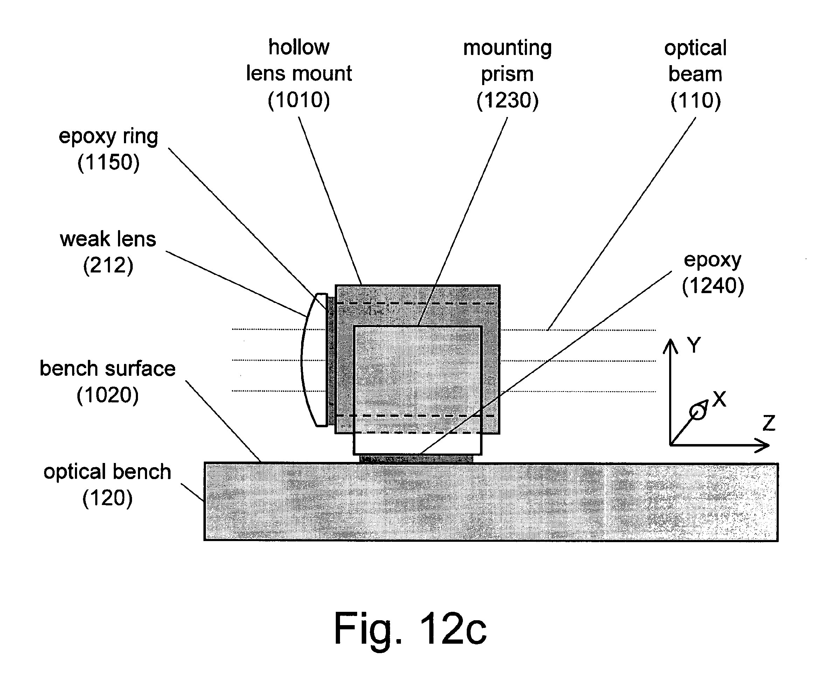

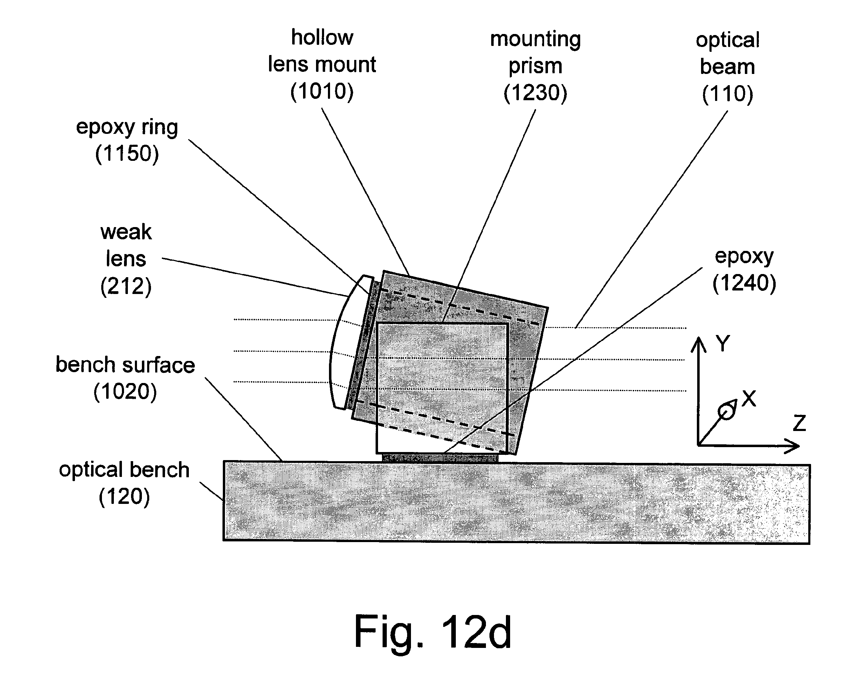

Figures 12a-d show a preferred method of adjusting and then permanently positioning the weak lens as part of the optical train. Figures 12a and 12b show front views of a gripping arm (1210) that, by means of an adjustable tightening screw (1220), holds hollow lens mount (1010) to which weak lens (212) is immovably affixed, for example by a ring of epoxy adhesive (1150) as shown in Fig. 12c. The gripping arm is mounted on a fixed base and is capable of moving lens mount (1010) containing lens (212) along all or any of the X, Y, and Z axes, and also of tilting the lens mount in pitch and/or yaw as shown in Fig. 12d. Gripping arm (1210) is operably connected to a base that permits movement of gripper (1210) as aforesaid until the optimum focus and position of the optical beam is achieved. The gripper (1210) (and the lens mount it is holding) are then maintained absolutely stationary until the weak lens mount is rigidly and permanently affixed as shown in Figs. 12b-12d. Once the lens has been oriented by arm (1210) to achieve optimum alignment/focusing of the optical beam with the waveguide, it is necessary to permanently attach the aligned weak lens mount to the optical bench or base plate with the minimum amount of alteration of its position and orientation relative to the remainder of the optical train components. We have found that one advantageous way of achieving this is by means of a mounting prism (1230 in Figs. 12b-d). With the lens mount (1010) held immoveable by the gripping arm (not shown in the side views of Figs. 12c and 12d), the prism is coated with a curable adhesive (e.g., thermal- or UV-cure epoxy 1240 and 1242) and pressed against the flat side of the lens mount (1010) and surface (1020) of the base plate (120). As soon as the adhesive has cured, the gripping arm releases the lens mount, which is now affixed to the optical table and permanently positioned relative to the remainder of the optical train.

The foregoing detailed description of the invention includes passages that are chiefly or exclusively concerned with particular parts or aspects of the invention. It is to be understood that this is for clarity and convenience, that a particular feature may be relevant in more than just the passage in which it is disclosed, and that the disclosure herein includes all the appropriate combinations of information found in the different passages. Similarly, although the various figures and descriptions herein relate to specific embodiments of the invention, it is to be understood that where a specific feature is disclosed in the context of a particular figure or embodiment, such feature can also be used, to the extent appropriate, in the context of another figure or embodiment, in combination with another feature, or in the invention in general.

Further, while the present invention has been particularly described in terms of certain preferred embodiments, the invention is not limited to such preferred embodiments. Rather, the scope of the invention is defined by the appended claims.

## Claims

1. Apparatus for coupling a collimated light beam into a waveguide comprising:
(i) a strong focussing lens interposed between the source of said collimated light beam and said waveguide; and
(ii) a weak lens positioned in the path of said collimated light beam either between said source and said strong lens or between said strong lens and said waveguide, said weak lens being translatable along the path of said collimated beam and also having at least one degree of positional freedom in a plane perpendicular to said beam path.

2. Apparatus in accordance with Claim 1 wherein said weak lens has two degrees of positional freedom in a plane perpendicular to said beam path and/or wherein said weak lens has at least one orientational degree of freedom.

3. Apparatus in accordance with claim 2 wherein said weak lens can be tilted to adjust both its pitch and its yaw.

4. Apparatus in accordance with any preceding claim wherein said weak lens has a focal length with an absolute value in the range of 10mm to 500mm.

5. Apparatus in accordance with claim 4 wherein said absolute value is in the range of 20mm to 200mm.

6. Apparatus in accordance with any preceding claim wherein said weak lens has a focal length with an absolute value in the range of from about 10 to about 100 times that of the strong lens.

7. Apparatus in accordance with claim 6 wherein said weak lens has a focal length the absolute value of which is from about 20 to about 50 times that of the strong lens.

8. Apparatus in accordance with any preceding claim wherein said weak lens is a positive lens or wherein said weak lens is plano convex.

9. Apparatus in accordance with any preceding claim wherein said waveguide is a SOA, ridge waveguide, single mode optical fiber or frequency doubling crystal.

10. Apparatus in accordance with any preceding claim comprising an external cavity semiconductor laser.

11. Apparatus in accordance with any preceding claim wherein said source of collimated light comprises a strong collimating lens interposed between said beam source and said focusing lens.

12. Apparatus in accordance with any preceding claim having an optical isolator interposed between said beam source and said focusing lens.

13. Apparatus in accordance with any preceding claim wherein said source of collimated light comprises a pump laser and said waveguide comprises a frequency doubling crystal.

14. Apparatus in accordance with any preceding claim wherein said frequency doubling crystal comprises periodically poled Potassium Titanyl Phosphate, periodically poled Lithium Niobate or periodically poled Lithium Tantalate.

15. Apparatus in accordance with any preceding claim wherein said weak lens is fixedly held in a lens mount contained within a housing, said lens mount being vertically moveable within said housing and said housing being translatable along said beam path and also transverse to said beam path.

16. An external cavity laser comprising: i) a ridge waveguide gain chip, ii) a wavelength selective reflective element which reflects radiation emitted by said gain chip back into said gain chip, iii) a weak lens, and iv) a strong lens which both collimates and focuses said radiation, said strong lens being interposed in said cavity between said gain chip and said reflective element.

17. An external cavity laser in accordance with claim 16 wherein said wavelength selective reflective element comprises in combination a high reflecting mirror and a tuning filter.

18. A process for achieving maximum coupling efficiency of a collimated optical beam into a waveguide comprising the steps of:
(i) interposing a weak lens and a strong lens between the source of said optical beam and said waveguide;
(ii) adjusting the position of said strong lens until the beam power into said waveguide is at or approximately at a maximum value;
(iii) permanently affixing said strong lens and said waveguide to a common rigid support; and
(iv) adjusting the position of said weak lens along the optical beam axis and along at least one axis perpendicular to said optical beam axis to the extent necessary to recover at least the majority of any coupling efficiency of said optical beam into said waveguide lost as a result of said permanent affixing of said strong lens and said waveguide.

19. A process in accordance with claim 18 wherein said weak lens is adjusted along both of the axes which are perpendicular to the optical beam axis and/or wherein at least one of the pitch and yaw of said weak lens is adjusted.

20. A process in accordance with claim 18 wherein said waveguide comprises a ridge waveguide, frequency doubling crystal, SOA or single mode optical fiber.

21. A process for achieving maximum coupling efficiency of a collimated optical beam into a ridge waveguide gain chip comprising the steps of:
a. interposing a weak lens and a strong lens between said waveguide and a wavelength selective reflective element which reflects radiation emitted by said gain chip back into said gain chip;
b. adjusting the position of said strong lens until the radiation reflected back into said gain chip is at or approximately at a maximum value;
c. permanently affixing said strong lens, said reflective element and said waveguide to a common rigid support and;
d. adjusting one or more of (i) the position of said weak lens along the optical beam axis (ii) the position thereof along at least one axis perpendicular to said optical beam axis and (iii) the pitch and/or yaw thereof to the extend necessary to recover at least the majority of any coupling efficiency of said light beam into said waveguide lost as a result of said permanent affixing of said reflective element, said strong lens and said waveguide.
